Europäisches Patentamt

**European Patent Office**

**Office européen des brevets**

(11) Numéro de publication: **0 161 981**
A2

(12) **DEMANDE DE BREVET EUROPEEN**

(21) Numéro de dépôt: **85400842.2**

(22) Date de dépôt: **29.04.85**

(51) Int. Cl.⁴: **H 01 L 23/52,** H 01 L 21/90

(30) Priorité: **11.05.84 FR 8407293**

(43) Date de publication de la demande: **21.11.85**
**Bulletin 85/47**

(84) Etats contractants désignés: **DE FR GB IT NL**

(71) Demandeur: **SOCIETE POUR L'ETUDE ET LA FABRICATION DE CIRCUITS INTEGRES SPECIAUX - E.F.C.I.S., 17, avenue des Martyrs, F-38100 Grenoble (FR)**

(72) Inventeur: **Marty, Michel, THOMSON-CSF SCPI 173, bld Haussmann, F-75379 Paris Cedex 08 (FR)**
Inventeur: **Baudrant, Annie, THOMSON-CSF SCPI 173, bld Haussmann, F-75379 Paris Cedex 08 (FR)**
Inventeur: **Passerat, Alain, THOMSON-CSF SCPI 173, bld Haussmann, F-75379 Paris Cedex 08 (FR)**

(74) Mandataire: **Guérin, Michel et al, THOMSON-CSF SCPI 173, Bld Haussmann, F-75379 Paris Cédex 08 (FR)**

(54) Circuits intégrés à plusieurs niveaux d'interconnexion en alliage d'aluminium, et procédé de fabrication.

(57) L'invention concerne les circuits intégrés à plusieurs niveaux d'interconnexion.

Le premier niveau (16) est un alliage ternaire d'aluminium, le second (24) est un autre alliage d'aluminium, et ils sont séparés par du tantale (22) dans les zones de contact entre les deux niveaux. En pratique, tout le deuxième niveau est constitué par la superposition d'une couche mince de tantale (22) et d'un alliage d'aluminium/silicium (24).

On évite les problèmes de surgravure du premier niveau pendant la gravure du second niveau.

# CIRCUITS INTEGRES A PLUSIEURS NIVEAUX D'INTERCONNEXION EN ALLIAGE D'ALUMINIUM ET PROCEDE DE FABRICATION

La présente invention se rapporte au domaine des circuits intégrés, et elle concerne plus précisément les étapes de fabrication dans lesquelles on réalise des interconnexions métalliques entre les divers éléments (notamment les transistors) formés à la surface ou dans le volume d'un substrat de circuit intégré.

On cherche de plus en plus à réaliser plusieurs niveaux successifs d'interconnexions de manière à augmenter la complexité des circuits qu'on peut intégrer sur une surface donnée. Ainsi, une première couche d'interconnexion métallique est déposée, et gravée selon un premier motif d'interconnexions entre des éléments de circuit réalisés auparavant ; puis, une couche isolante est déposée et gravée pour ouvrir des fenêtre d'accès ponctuel à la première couche ; enfin, une deuxième couche métallique est déposée et gravée selon un deuxième motif d'interconnexion.

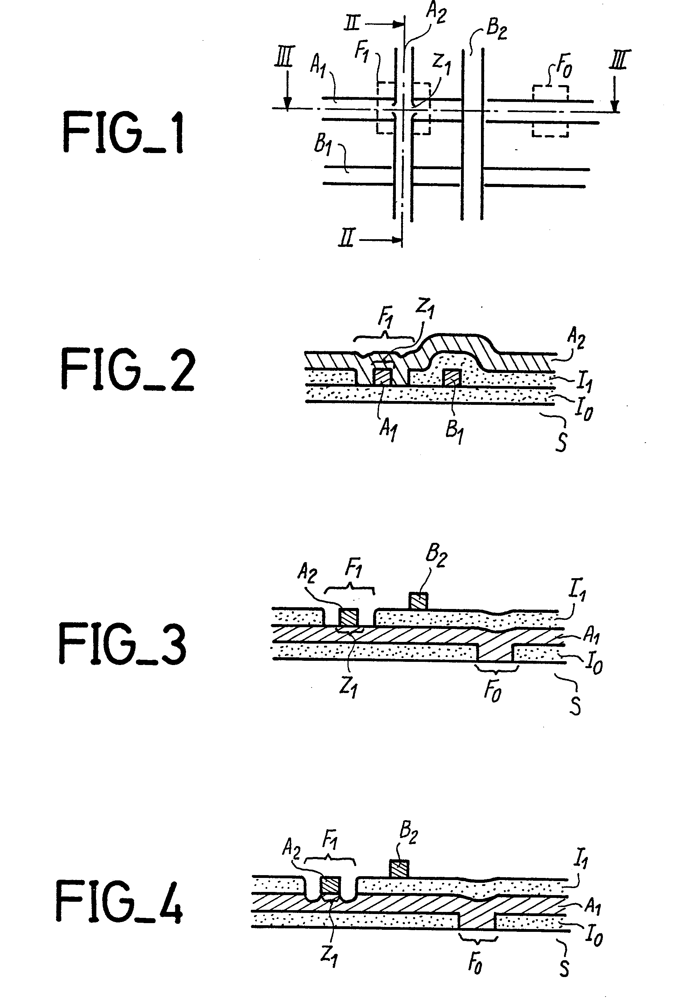

La figure 1 représente symboliquement, en vue de dessus, deux conducteurs de ligne A1 et B1 d'une première couche d'interconnexion, et deux conducteurs de colonne A2 et B2 d'une deuxième couche d'interconnexion. Les conducteurs A1 et A2 se croisent et sont en contact l'un avec l'autre dans une zone de contact Z1 à l'endroit du croisement. Par contre, le conducteur A2 est isolé du conducteur B1 à l'endroit où il le croise ; de même, le conducteur B2 est isolé du conducteur A1 comme du conducteur B1 là où il les croise.

Entre les conducteurs A2, B2 de la deuxième couche d'inter-connexion et les conducteurs A1, B1 de la première couche, on trouve une couche d'isolant I1 sauf dans une fenêtre F1 qui contient la zone de contact Z1 entre les conducteurs A1 et A2.

On peut imaginer à titre d'exemple que le conducteur A1 repose généralement sur une couche d'isolant I0 recouvrant le

substrat S, sauf dans une fenêtre FO où la couche d'isolant IO est ouverte et où le conducteur A1 est en contact avec une zone semiconductrice du substrat S (source ou drain d'un transistor par exemple).

La figure 2 et la figure 3 représentent en coupe verticale la structure qui résulte de la description qui précède. La figure 2 est une coupe selon la ligne II-II de la figure 1, c'est-à-dire le long du conducteur de colonne A2 ; la figure 3 est une coupe selon la ligne III-III de la figure 1, c'est-à-dire le long du conducteur de ligne A1.

Pour des raisons de précision de positionnement de la fenêtre F1 au carrefour des conducteurs A1 et A2, on est amené à prévoir que cette fenêtre a des dimensions, largeur et longueur, supérieures à la largeur des conducteurs A1 et A2.

Il en résulte des défauts de fabrication qui vont être expliqués ci-après en exposant le procédé de fabrication de la structure décrite aux figures 1 à 3 : ayant réalisé des éléments semiconducteurs intégrés dans un substrat S, on recouvre ce substrat d'une couche isolante IO, par exemple en oxyde de silicium ; on grave cette couche pour ouvrir les fenêtres FO là où l'on doit réaliser un contact avec un élément du substrat sous-jacent, par exemple un transistor ; on dépose une première couche métallique d'interconnexion que l'on grave pour former un premier motif d'interconnexion désiré (lignes A1 et B1) ; on dépose une autre couche isolante I1 (oxyde de silicium par exemple) ; on la grave pour ouvrir des fenêtres F1 englobant des zones de contact Z1 désirées, les fenêtres F1 étant plus larges que ces zones Z1 ; on dépose alors la deuxième couche métallique d'interconnexion, que l'on grave pour former un deuxième motif d'interconnexion désiré (lignes A2 et B2).

Un premier problème réside dans le choix des métaux d'interconnexion. L'aluminium est un métal courant, facile à déposer et à graver. Mais, il a une tendance à se recristalliser après le dépôt et à former des irrégularités superficielles gênantes ("hillocks"). De plus, l'aluminium s'allie au silicium créant ainsi des défauts dans le silicium monocristallin notamment au niveau des prises de contact sur zones actives de sources et de drain. Pour éviter ces deux problèmes, on dépose non pas de l'aluminium pur mais un alliage ternaire d'aluminium, de silicium et d'un troisième métal qui a surtout été jusqu'à maintenant le cuivre.

Malheureusement, l'alliage ternaire Al-Si-Cu, s'il peut être correctement gravé par gravure chimique, est mal adapté à une gravure sèche (par plasma ou en gravure ionique réactive) avec les produits d'attaque usuels : il subsiste après gravure des résidus de chlorures de cuivre conducteurs susceptibles de provoquer des court-circuits. La gravure sèche serait pourtant bien préférable à la gravure chimique pour la définition des motifs d'interconnexion, du fait de sa directivité (gravure anisotrope verticale) qui permet un réel contrôle dimensionnel.

Le choix qu'on fait ici comme métal d'interconnexion est un mélange ternaire d'aluminium, silicium et tantale, ou éventuellement aluminium, silicium et titane, qui résolvent les problèmes cités ci-dessus (absence de recristallisation, faible électromigration, possibilité de gravure sèche avec un composé chloré tel que le tétrachlorure de carbone $CCl_4$).

Cependant, si tout se passe bien lors de la gravure de la première couche d'interconnexion en alliage ternaire Al-Si-Ta, on se heurte à une difficulté lors de la gravure de la deuxième couche (qui d'ailleurs peut être en alliage binaire Al-Si et non ternaire) : on cherche à graver la deuxième couche par gravure sèche ; mais on contrôle mal la profondeur de cette gravure, et l'alliage Al-Si-Ta de la première couche (ligne A1), mis à nu dans la fenêtre F1, risque d'être attaqué partiellement à la fin de la gravure des lignes A2, B2 de la deuxième couche. Ceci résulte de ce que la largeur de la fenêtre F1 est plus grande que la largeur du conducteur A2.

On risque en fait d'aboutir à une structure qui, au lieu d'être celle de la figure 3, est plutôt celle de la figure 4 où le conducteur A1 est partiellement, voire totalement, coupé de part et d'autre de la zone de contact avec le conducteur A2 dans la fenêtre F1. Une coupure totale est évidemment rédhibitoire, mais même une coupure partielle est gênante car elle entraîne une réduction de la section de passage du courant, préjudiciable au bon fonctionnement des circuits.

Pour remédier à cet inconvénient, il s'est avéré nécessaire en général de faire en sorte que le conducteur A2 soit élargi au niveau du contact Z1 à une dimension supérieure à celle de la fenêtre F1, mais cela entraîne une augmentation de la distance minimale de garde à prévoir entre les lignes adjacentes de conducteurs d'un motif d'interconnexion, donc une réduction de la densité d'intégration.

La présente invention propose un procédé de fabrication de circuits intégrés à au moins deux niveaux d'interconnexion métalliques présentant entre eux des zones de contact ponctuelles, ce procédé comprenant des étapes analogues à celles qui ont été décrites en référence aux figures 1 à 4, à savoir :

a) dépôt d'une première couche d'interconnexion constituée par un alliage ternaire d'aluminium,

b) gravure sèche sélective de la première couche, à travers un masque ouvert selon un motif d'interconnexion désiré,

c) dépôt d'une couche isolante,

d) gravure de cette couche isolante pour ouvrir des fenêtres à l'endroit des zones de contact désirées, les fenêtres étant plus larges que les zones de contact,

e) dépôt d'une deuxième couche d'interconnexion constituée par un alliage d'aluminium,

f) gravure sèche sélective, à partir d'un composé chloré, de la deuxième couche, à travers un masque ouvert selon un autre motif d'interconnexion désiré.

Le procédé selon l'invention comporte de plus, entre les étapes d) et e), à savoir après la gravure des fenêtres de la couche isolante et avant le dépôt de la deuxième couche d'alliage d'aluminium, le dépôt d'une couche mince de tantale. La deuxième couche d'alliage d'aluminium est gravée au moyen d'un composé chloré ; le tantale qui subsiste après cette gravure est alors éliminé là où il n'est pas recouvert d'alliage d'aluminium, sans opération de masquage (ou avec le même masque qui vient de servir pour la gravure de la deuxième couche), au moyen d'un produit d'attaque sélectif par rapport à l'alliage d'aluminium et au matériau constituant la couche isolante.

Par "gravure sèche", on entend dans la présente description une gravure qui ne s'effectue pas dans un bain chimique mais dans un bâti de gravure par plasma ou de gravure ionique réactive.

D'autres caractéristiques et avantages de l'invention apparaîtront à la lecture de la description détaillée qui suit et qui est faite en référence aux dessins annexés dans lesquels :

- les figures 1 à 4 déjà décrites, représentent une structure d'interconnexions à deux niveaux de la technique antérieure,

- les figures 5 à 9 représentent une première variante du procédé de fabrication selon l'invention.

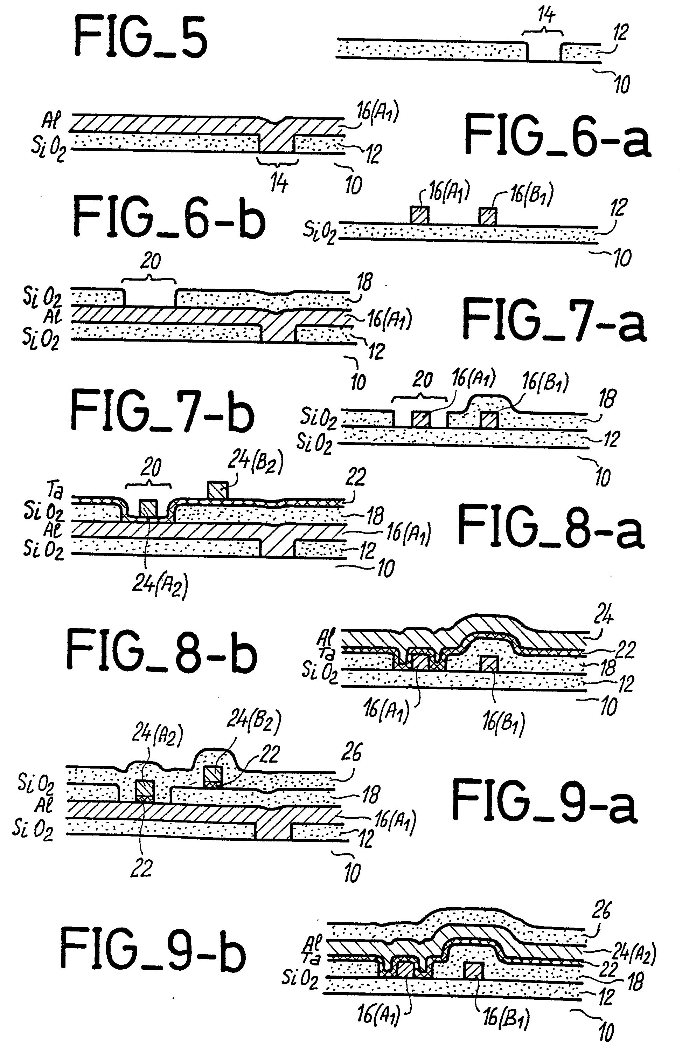

Sur la figure 5, on a représenté un substrat 10 qui peut être un substrat de silicium dans lequel on a réalisé un certain nombre d'éléments de circuit non représentés, et notamment des transistors. La surface supérieure de ce substrat a été représentée plane pour simplifier, mais il faut comprendre qu'elle peut être fortement modelée par les circuits sous-jacents.

On recouvre cette surface d'une couche isolante 12, par exemple en oxyde de silicium (SiO ou $SiO_2$)déposé a basse pression, sur laquelle reposera ultérieurement la première couche d'interconnexion.

On grave cette couche isolante 12 pour ouvrir des fenêtres 14 là où une première couche d'interconnexion métallique devra venir en contact avec des éléments de circuit sous-jacents à la couche 12 (figure 5).

On dépose, par pulvérisation dans un bâti prévu a cet effet, une couche métallique sous la forme d'un tri-couche Aluminium/Tantale/Aluminium, les couches d'aluminium contenant du silicium, et le tantale pouvant éventuellement être remplacé par un autre métal tel que le titane ; l'épaisseur de la couche 16 est inférieure au micron.

Les proportions d'aluminium de silicium et de tantale peuvent être les suivantes : silicium environ 1,5 %, tantale environ 10 %, aluminium environ 90 %.

On grave cette couche 16 d'aluminium dans un bâti de gravure sèche (gravure anisotrope verticale au plasma ou gravure ionique réactive, à partir d'un composé chloré tel que le tétrachlorure de carbone $CCl_4$ après masquage par une résine peu attaquée par le produit d'attaque utilisé. Le masquage de résine définit le motif d'interconnexions du premier niveau d'interconnexion du circuit. On suppose ici que le motif comprend des lignes parallèles A1 et B1 comme à la figure 1 et que la figure 6a représente une section longitudinale du circuit le long de la ligne A1, la figure 6b représentant une section transversale, coupant cette ligne.

On dépose alors, par décomposition chimique en phase vapeur et à basse pression, une couche isolante 18 (oxyde de silicium SiO ou $SiO_2$ de préférence) qui servira à isoler l'un par rapport à l'autre les deux niveaux d'interconnexion métallique prévus.

On grave la couche isolante 18 après masquage par une résine, pour ouvrir des fenêtres 20 dans lesquelles l'alliage d'aluminium de la couche 16 est mis à nu là où on désire un contact entre les deux niveaux d'interconnexion métallique. La largeur des fenêtres 20 est supérieure (au moins pour certains des contacts prévus) à la largeur des lignes du métal de la première couche, ainsi qu'à celle des lignes du métal de la deuxième couche, comme cela est représenté à la figure 1 à propos de la fenêtre F1 et des conducteurs A1 et A2 : il s'agit de fenêtres débordant tout autour des zones effectives de contact entre lignes et colonnes. On rappelle que ces fenêtres sont prévues suffisamment larges pour être sûr que malgré la dispersion de positionnement entre les trois masques successifs définissant respectivement le premier motif d'interconnexion, les fenêtres 20, et le deuxième motif d'interconnexion, il n'y ait pas de risque que la zone de contact finale entre deux conducteurs soit réduite par rapport à celle que permet un positionnement parfaitement aligné entre ces trois masques ; la structure qui en résulte est représentée aux figures 7a et 7b (correspondant respectivement aux sections longitudinale et transversale des figures 6a et 6b).

On dépose alors, par pulvérisation dans un bâti approprié, une couche mince 22 de tantale (0,05 à 0,1 microns par exemple), et ce dépôt est suivi immédiatement, dans le même bâti, du dépôt d'une deuxième couche 24 d'alliage d'aluminium (de l'ordre de un micron d'épaisseur) ; l'alliage est un alliage binaire (Al-Si) ou ternaire. Cette deuxième couche est gravée, en gravure sèche anisotrope verticale, au moyen d'un composé chloré ($CCl_4$ par exemple) apres masquage par une résine résistant à ce produit, le masque définissant le motif d'interconnexion de la deuxième couche (colonnes parallèles A2 et B2 sur les figures 8a et 8b qui sont des sections longitudinale et transversale correspondant aux figures 7a et 7b). Le conducteur A2 coupe le conducteur A1 à l'intérieur d'une fenêtre 20. Sur la figure 8b, on suppose que la coupe transversale effectuée se situe le long d'un conducteur de colonne A2.

Le tantale 22 est peu attaqué pendant cette gravure au moyen d'un composé chloré, de sorte qu'il protège contre une gravure l'alliage d'aluminium de la première couche 16 dans la fenêtre 20.

On peut alors, tout en restant dans le même bâti, avec le même masque ou sans masque du tout, éliminer le tantale partout ou il est mis à nu, c'est-à-dire là où il n'est pas protégé par l'aluminium du deuxième niveau d'interconnexion, par gravure sèche au moyen d'un composé fluoré, par exemple de l'hexafluorure de soufre $SF_6$.

Si l'élimination du tantale se fait par gravure sèche, on peut facilement arrêter cette gravure par détection de l'apparition de produits résultant du début d'attaque de l'oxyde épais de la couche 18.

Dans la suite des étapes de fabrication du circuit intégré, le tantale subsistant sous la deuxième couche d'interconnexion s'allie étroitement avec les composés de cette couche et forme une couche mince à forte concentration de tantale sous la couche principale d'alliage d'aluminium du deuxième niveau.

Il subsiste, à la fin de ces étapes, une structure semiconductrice à deux niveaux d'interconnexions présentant entre eux des zones de contact ponctuelles, dans laquelle :

- l'un des niveaux d'interconnexion est constitué par un alliage ternaire d'aluminium (16),

- les zones de contact sont constituées par une superposition d'un alliage ternaire d'aluminium (16), d'une couche mince à forte concentration de tantale (22), et d'un deuxième alliage d'aluminium (24),

- l'autre niveau d'interconnexion est constitué partout par la superposition d'une couche mince (22) à forte concentration de tantale et d'une couche d'alliage d'aluminium (24),

- bien entendu, si l'alliage d'aluminium du premier ou du deuxième niveau est un alliage contenant du tantale, la concentration en tantale à la partie inférieure du deuxième niveau est très supérieure à la concentration dans le reste du premier ou deuxième niveau.

Cette structure, visible aux figures 9a et 9b, peut être à nouveau recouverte d'une couche isolante 26 de passivation ou d'une couche isolante servant à séparer le deuxième niveau d'interconnexion d'un troisième niveau réalisé de la même manière que le deuxième.

On réalise ainsi des structures multi-couches d'interconnexion avec un procédé particulièrement simple ne nécessitant pas un accroissement de l'espacement entre lignes de conducteurs.

REVENDICATIONS

1. Circuit intégré à au moins deux niveaux d'interconnexions métalliques présentant entre eux des zones de contact ponctuelles, dans laquelle le premier niveau d'interconnexion est constitué par une première couche (16) d'un alliage ternaire d'aluminium, caractérisé en ce que le deuxième niveau est constitué partout par une superposition d'une couche mince (22) à forte concentration de tantale et d'une couche (24) d'alliage d'aluminium, la couche mince à forte concentration de tantale étant alliée aux alliages d'aluminium des premier et deuxième niveaux dans les zones de contact entre ces niveaux.

2. Circuit intégré selon la revendication 1, caractérisé en ce que l'alliage ternaire est un alliage d'aluminium, silicium et tantale, la concentration en tantale à la partie inférieure du deuxième niveau étant très supérieure à la concentration en tantale dans le reste du deuxième niveau.

3. Procédé de réalisation d'un circuit intégré à plusieurs niveaux d'interconnexion comprenant les étapes suivantes :
- a) dépôt d'une première couche d'interconnexion (16) constituée par un alliage ternaire d'aluminium,
- b) gravure sèche sélective, de la première couche d'interconnexion, à travers un masque ouvert selon un motif d'interconnexion désiré (A1, B1),
- c) dépôt d'une couche isolante (18),
- d) gravure de cette couche isolante (18) pour ouvrir des fenêtres (20) à l'endroit des zones de contact prévues entre la première couche d'interconnexion et une deuxième couche d'interconnexion, les fenêtres étant plus larges que les zones de contact effectives désirées,
- e) dépôt d'une deuxième couche d'interconnexion (24) constituée par un alliage d'aluminium,

- f) gravure sèche sélective, à partir d'un composé chloré, de la deuxième couche d'interconnexion (24), à travers un masque ouvert selon un autre motif d'interconnexion désirée (A2, B2), caractérisé en ce que, entre les étapes d) et e), on effectue le dépôt d'une couche mince de tantale (22).

4. Procédé selon la revendication 3, caractérisé en ce que le tantale non recouvert par l'alliage d'aluminium de la deuxième couche, après gravure de cette dernière à l'étape f), est éliminé sans étape de masquage supplémentaire, au moyen d'un produit d'attaque sélectif par rapport à l'aluminium.

5. Procédé selon la revendication 4, caractérisé en ce que le tantale est éliminé par gravure sèche réactive au moyen d'un composé fluoré.

6. Procédé selon la revendication 3, caractérisé en ce que le tantale est déposé par pulvérisation immédiatement avant le dépôt de la deuxième couche d'alliage d'aluminium, et dans le même bâti de pulvérisation.

FIG_1

FIG_2

FIG_3

FIG_4

0161981

2/2

FIG_5

FIG_6-a

FIG_6-b

FIG_7-a

FIG_7-b

FIG_8-a

FIG_8-b

FIG_9-a

FIG_9-b